# EUROPÄISCHE PATENTANMELDUNG

(11) **EP 0 992 617 A2**
(43) Veröffentlichungstag der Anmeldung: **12.04.2000**
(21) Anmeldenummer: 99116594.5
(22) Anmeldetag: 25.08.1999
(51) Int. Cl.: C25D 17/00, H05K 3/24

(54) **Einrichtung zur Behandlung von Gegenständen, insbesondere Galvanisiereinrichtung für Leiterplatten**

(30) Priorität: 19.09.1998 DE 19842974
(71) Anmelder: Gebr. Schmid GmbH & Co., D-72250 Freudenstadt (DE)
(72) Erfinder: Schmid, Dieter C., 72250 Feudenstadt (DE)
(74) Vertreter: Patentanwälte Ruff, Beier, Schöndorf und Mütschele

(57) **Zusammenfassung**

Eine Durchlauf-Galvanisieranlage für Leiterplatten (13) ist mit einer außerhalb der Behandlungskammer (11) liegenden Aufbereitungsanlage (78) für den Elektrolyten verbunden, in der z.B. das für eine Kupferbeschichtung notwendige Kupfer dem Elektrolyten zugesetzt wird. In der Behandlungskammer sind als Elektroden (71) die Außenoberflächen der Wellen (41) von Transportwalzen vorgesehen. Die Leiterplatten (13) werden zwischen isolierenden Ringen (42) geführt, die in axialen Abstand voneinander auf die Wellen (41) aufgebracht sind. Die Stromzuführung zu den Elektroden (71) erfolgt über außen liegende Schleifringe (76). Es wird somit ein sehr großflächiger Elektrodenaufbau geschaffen.

## Beschreibung

### ANWENDUNGSGEBIET UND STAND DER TECHNIK

Die Erfindung betrifft eine Einrichtung zur Behandlung von Gegenständen, insbesondere eine Galvanisiereinrichtung für Leiterplatten nach dem Oberbegriff des Anspruchs 1.

Aus der EP-B-677 599 und der DE-A-196 28 784 sind derartige Einrichtungen bekannt geworden, bei denen die Kontaktiermittel mehrere elektrisch voneinander isolierte, im Behandlungsmedium umlaufende, elektrisch unterschiedlich kontaktierte Kontaktsektoren aufweisen. Sie sind in Umlaufrichtung abwechselnd kathodisch und anodisch an die Stromversorgung anschließbar. Dadurch ist es möglich, im kathodisch kontaktierten Bereich eine Stromzuführung zu den Gegenständen vorzunehmen. Die dabei sich zwangsläufig ergebende mehr oder weniger starke Metallisierung der Kontaktierungsflächen wird dann im anodisch beaufschlagten Bereich wieder entfernt. Die Anoden werden dabei durch das Behandlungsmaterial gebildet, also beispielsweise das Kupfer, das auf die Gegenstände galvanisch aufgebracht werden soll.

Die Anoden sind meist als elektrisch leitend angeschlossene Körbe ausgebildet, in denen beispielsweise Kupferkugeln liegen.

Es ist bereits vorgeschlagen worden, die Ergänzung der Elektrolytlösung mit dem Behandlungsmaterial außerhalb der eigentlichen Behandlungskammer vorzunehmen und die dort aufgefrischte Elektrolytlösung in die Behandlungskammer zurückzupumpen. Im Fall einer galvanischen Beschichtung kann also dann die Anode aus einem unter Galvanikbedingungen unlöslichen bzw. inerten Material bestehen.

### AUFGABE UND LÖSUNG

Aufgabe der Erfindung ist es, eine Einrichtung der eingangs erwähnten Art in Bezug auf ihre Wirtschaftlichkeit und auf einen gedrängten und unkomplizierten Aufbau der Einrichtung weiter zu verbessern.

Diese Aufgabe wird durch den Anspruch 1 gelöst.

Bei einer Galvanisiereinrichtung können also die Transportmittel, vorzugsweise die rohrförmigen Wellen der Transportwalzen, die Elektroden, z.B. die Anoden, bilden. Die eigentlichen Führungsteile, also beispielsweise auf diesen Wellen laufende elektrisch isolierende Reifen oder Ringe, stellen einen sicheren, aber geringen Abstand zwischen den anodischen Wellen und den zu beschichtenden Gegenständen sicher. Die Elektroden können daher sehr großflächig und praktisch entlang der gesamten Transportstrecke mit diesem geringen Abstand wirksam sein, ohne daß die Gegenstände gegenüber den Anoden abgedeckt werden.

Gerade bei sehr dünnen Leiterplatten sollten die Transportwalzen in axialer Richtung sehr eng angeordnet sein, um zu vermeiden, daß die fast papierdünnen Platten aus der Transportbahn abweichen. Dies würde bei herkömmlicher Anodenanordnung wegen der dadurch entstehenden Abschirmung Probleme schaffen, ist aber ideal für die Anwendung der Erfindung. In einem solchen Falle könnte eventuell sogar auf die Verwendung aller Transportwalzen als Elektroden verzichtet werden.

Die Kontaktierung der Transportmittel kann über außerhalb der Behandlungskammer angeordnete Schleifkontakte erfolgen. Vorzugsweise erfolgt auch die (z.B. kathodische) Kontaktierung der Gegenstände über auf einem sogenannten seitlichen Galvanorand der Gegenstände laufende Kontaktsektoren, die abwechselnd kathodisch und anodisch kontaktiert sind, um sich selbst wieder zu entmetallisieren. Zu diesem Zweck ist ohnehin eine weitgehend flüssigkeitsdichte Durchführung der Transportwalzen, auf denen die Kontakträder angeordnet sind, in eine spezielle Kontaktierungskammer nötig. Die Kombination dieser mit abwechselnd anodisch und kathodisch gepolten Kontaktsektoren arbeitenden Stromzuführung zu den Gegenständen mit der Elektrodenausbildung der Wellen ist also besonders vorteilhaft.

Die Führungsteile können, wie in der EP-A-750 455 beschrieben, ihre axiale Position über den Umfang der Transportwalze ändern, beispielsweise mit einer Schraubensteigung versehen sein. Dadurch wird vermieden, daß durch die stets an der gleichen Stelle laufenden Führungsteile Markierungen oder Beschichtungs-Inhomogenitäten auftreten. Gleichzeitig wird aber dadurch der Elektrolyt in dem Galvanospalt zwischen anodischer Welle und kathodischem Gegenstand auf die wirksamste Weise und unmittelbar umgewälzt und ständig erneuert.

Durch die geringen Abstände und die großflächige Elektrodenanordnung sind die anzulegenden Spannungen gering, was die Wirtschaftlichkeit des Galvanisierverfahrens steigert. Ferner wird vermieden, daß das Verbrauchsmaterial, z.B. Kupfer, in die Behandlungskammer nachgeladen werden muß, was Betriebsstillstände erfordern würde. Durch das Vermeiden zusätzlicher Elektroden kan auch die Behandlungskammer kompakter gebaut werden. Es entfällt auch die Gefahr, daß feste Partikel des Verbrauchsmaterials i die Behandlungsflüssigkeit geraten und sich auf der Beschichtung absetzen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### KURZBESCHREIBUNG DER ZEICHNUNG

Ein Ausführungsbeispiel der Erfindung ist in der einzigen Zeichnung dargestellt, und zwar
- als schematischer Teilquerschnitt durch eine Galvanisiereinrichtung für Leiterplatten.

### BESCHREIBUNG DES AUSFÜHRUNGSBEISPIELS

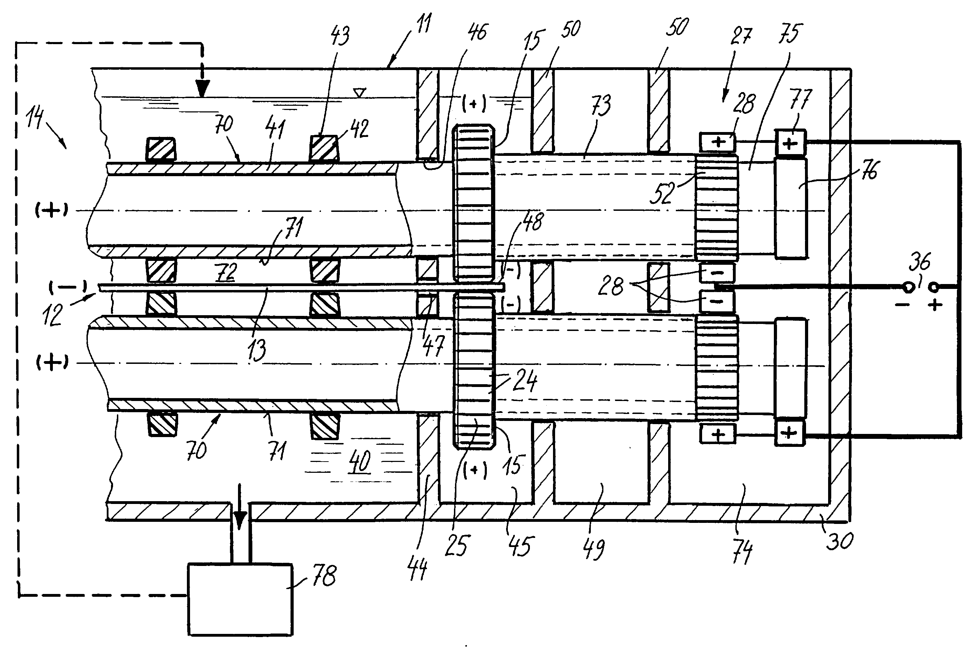

Fig. 1 zeigt schematisch einen Teil einer Galvanisiereinrichtung mit einer Behandlungskammer 11, die mit einem Behandlungsmedium 40, beispielsweise einer Elektrolytlösung, gefüllt ist. In der langgestreckten Behandlungskammer 11 ist eine horizontale Durchlaufbahn 12 mit einer senkrecht zur Zeichenebene verlaufenden Transportrichtung für zu behandelnde Gegenstände 13, insbesondere elektrische Leiterplatten, ausgebildet. Sie werden auf der Durchlaufbahn 12 horizontal liegend durch die Behandlungskammer 11 gefördert. Die Durchlaufbahn 12 wird von Transportmitteln 14 in Form eines Rollenförderers mit Transportwalzen 70 oder -rädern gebildet. Die Transportwalzen 70 sind jeweils paarweise über und unter der Durchlaufbahn, in axialer Richtung relativ eng aneinander angrenzend angeordnet. Sie bestehen jeweils aus einer Welle 41 in Form eines Rohres aus elektrisch leitenden Material. Dieses Material kann selbst in Bezug auf den auszuführenden Galvanikprozeß inert sein oder mit einer solchen inerten Beschichtung versehen sein. Das jeweils geeignete Material bestimmt sich nach der Art des Galvanikprozesses (galvanischer Materialauftrag oder -abtrag, verwendete Chemikalien etc.). Auf der Welle sind ring- oder reifenförmige Führungsteile oder -scheiben 42 aus elektrisch isolierendem Material vorgesehen, die an ihrer Außenseite die eigentliche Lauffläche 43 aufweisen, zwischen denen die Gegenstände 13 geführt und transportiert werden.

Die Welle 41 hat im Vergleich zum Gesamtdurchmesser der Transportwalze (Durchmesser der Laufflächen 43) einen relativ großen Durchmesser, vorzugsweise mehr als die Hälfte bis zwei Drittel.

Die einzelnen Führungsteile 42 haben außerdem einen Abstand voneinander, der im Vergleich zu ihrer Breite relativ groß ist und beispielsweise das Vier- bis Fünffache der Scheibenbreite betragen und/oder dem Transportwalzendurchmesser entsprechen kann. Dadurch ist die freie Metalloberfläche der Welle 41, die, wie später noch erläutert wird, eine Elektrode 71 bildet, relativ groß und hat im engsten Spalt 72 zwischen der Elektrode 71 und dem zu behandelnden Gegenstand 13 nur einen relativ geringen Abstand von diesem. Die Führungsteile 42 bestehen normalerweise aus einen Kunststoff mit guten Elastizitäts- und Beständigkeitseigenschaften.

Die Wellen 41 der gegenläufig angetriebenen Transportwalzen 70 ragen durch eine Trennwand 44 der Behandlungskammerwandung 30 hindurch, die eine Kontaktierkammer 45 von der übrigen Behandlungskammer 11 weitgehend abtrennt. Sie ist jedoch mit dieser durch die Durchgangsöffnungen 46 für die Wellen 41 und durch einen Längsschlitz 47 mit dieser verbunden, durch den der Gegenstand 13 bis in die Kontaktierkammer hineinragt und längs dessen er horizontal geführt ist.

An dem in der Kontaktierkammer 45 verlaufenden Randbereich hat der Gegenstand 13 einen sogenannten Galvanorand 48, d.h. einen Bereich, der hauptsächlich zur durchgehenden Kontaktierung während der Galvanisierung vorgesehen ist. Die Gegenstände 13 sind an den galvanisch zu behandelnden Flächenabschnitten mit einer elektrisch leitenden Schicht überzogen. Diese kann z.B. als Kupferkaschierung auf dem Basismaterial des Gegenstandes vorhanden sein. Die Innenfläche von in den Gegenständen vorgesehenen Bohrungen könnten vorher durch chemische Metallabscheidung elektrisch leitfähig gemacht worden sein.

Die elektrisch leitende Schicht auf den Gegenständen und in deren Bohrungen kann auch aus einem elektrisch leitenden Polymer, beispielsweise einem entsprechenden Kunststoff, aus Graphit oder ähnlichem bestehen.

Die Kontaktierkammer 45 ist nach außen hin durch einen Abdichtbereich 49 abgeschlossen, zu dem beispielsweise zwei Zwischenwände 50 gehören, durch die die Wellen 41 weitgehend abgedichtet hindurchragen. In diesem Bereich kann sich auch der nicht dargestellte Antrieb der Transportmittel 14 befinden, beispielswiese in Form von Kegelrädern, die von einer gemeinsamen Achse aus angetrieben sind. Sie sind hier zur Vereinfachung der Darstellung nicht gezeigt, ebenso wenig die Abdichtungssysteme, die z.B. nach Art eines Labyrinths arbeiten können.

In der Kontaktierkammer 45 sind auf den Wellen 41 Kontaktiermittel 15 vorgesehen, die aus je einer auf der Welle 41 angeordneten Scheibe bestehen, so daß sich zwei dieser Scheiben paarweise gegenüberstehen und den Galvanorand 48 von oben und unten berühren und mit ihren Kontaktflächen 25 elektrisch kontaktieren.

Die einzelnen Kontaktsektoren 24, die zu den Kontaktflächen 25 gehören, sind, z.B. in einem die Welle 41 umgebenden isolierenden Mantel 73, durch Leiterschienen mit entsprechenden Kommutatorsektoren 52 eines nach Art eines Kommutators ausgebildeten Stromzuleitmittels 27 verbunden, der von Stromzuleitungen 28 nach Art von Kollektorbürsten mit dem Galvanisierungsstrom beaufschlagt wird.

An dem Kommutator 27 sind zwei Stromzuleitungen 28 oder Gruppen von Stromzuleitungen vorgesehen, von denen die eine (Minus) die für den eigentlichen Galvanisierungsprozeß vorgesehene Polarität führt und über die Kontaktiermittel 15 den Gegenständen 13 zuleitet, während die andere (Plus) die Kontaktsektoren 24 in einem Bereich mit der entgegengesetzten Polarität beaufschlagt, in dem sie die Gegenstände 13 nicht kontaktieren. Sie dienen in später noch zu erläuternden Weise zur Rückgängigmachung von unerwünschten Galvanisierungsfolgen an den Kontaktiermitteln 15 bzw. ihren Kontaktflächen 25, beispielsweise zur Entkupferung bei einen galvanischen Kupferauftrag.

Die gleiche Polarität (im vorliegenden Beispiel Plus, also anodisch) wird an die Welle 41 angelegt. Ihr in den Kommutatorraum 74, der außerhalb der Behandlungsflüssigkeit liegt, hineinragendes freies Ende 75 trägt einen umlaufenden Schleifring 76, der von Stromzuleitungen 77 kontaktiert wird. Für alle Stromleitungen kann eine gemeinsame Stromversorgung 36 vorgesehen sein.

Das Behandlungsmedium 40 wird über eine außerhalb des Behandlungsraumes angeordnete Aufbereitungsanlage 78 ständig umgewälzt. In dieser werden die für die Behandlung notwendigen Materialien zugegeben bzw. entzogen. So wird für einen galvanischen Kupferauftrag dort Kupfer gelöst oder auf andere Weise zugegeben, während beispielsweise bei einer galvanischen Reinigung abgelöste Materialien dort entfernt werden. Entsprechend dem Zweck der galvanischen Behandlung (Auftrag oder Abtrag) ist auch die Polung der Gegenstände bzw. der Elektrode 71 unterschiedlich.

Die Anordnung der Stromzuführung zu den Elektroden 71 über Schleifringe 76, die auf der gleichen Seite liegen, wie die Stromzuführung 27 für die Gegenstände 13, ist besonders vorteilhaft, weil dort ohnehin eine Abdichtung im Abdichtbereich 49 vorgesehen ist. Grundsätzlich wäre aber auch eine Zuführung von der gegenüberliegenden Seite her möglich. Der beschriebene Wellenaufbau der Transportwalzen, die auch als als Transportrollen oder -scheiben bezeichnet werden können, kann auch anders sein. So können z.B. die Transportwalzen aus Kunststoff bestehen und die Elektrodenflächen als Überzug aus inertem Material aufgebracht sein.

### FUNKTION

Im folgenden wird die Funktion anhand einer Galvanisiereinrichtung zur Verkupferung von Leiterplatten erläutert.

Die von den Transportmitteln 14 waagerecht durch die mit Behandlungsmedium 40 gefüllte Behandlungskammer 11 geführten Gegenstände 13 werden von den gegenläufig angetriebenen Transportwalzen 70 transportiert und gleichzeitig an ihrer elektrisch leitenden Oberflächenschicht von den Kontaktflächen 25 der Kontaktsektoren der Kontaktiermittel kontaktiert. Diese stehen jeweils in dem dem Gegenstand 13 nahen Abschnitt mit dem Minuspol der Stromversorgung 26 in Kontakt, und zwar durch die nach Art von Kohlbürsten ausgebildeten Stromversorgungen 28 im Zusammenwirken mit den Kommutatorsektoren 52. In vom Gegenstand 13 abgewandten Bereichen stehen die Kontaktsektoren, ebenfalls über entsprechende Kommutatorsektoren 52 und Stromzuleitungen 28, mit dem Pluspol der Stromversorgung in Verbindung. Der dadurch zugeführte Entmetallisierungsstrom könnte auch von einer gesonderten Stromversorgung geliefert werden.

Der Pluspol der Galvanisierungs-Stromversorgung 36 ist über die Stromzuführung 77 und die Schleifringe 76 mit den Wellen 41 verbunden, deren Außenflächen im Bereich der Behandlungskammer 11 außerordentlich großflächige Elektroden 71 bilden, die im vorliegenden Fall Anoden sind. Die sonst üblichen Anodenkörbe mit sich auflösenden Kupferkugeln sind nicht notwendig.

Dafür wird das Behandlungsmediun 40 über die Aufbereitungsanlage 78 gefördert und nach entsprechender Aufbereitung, beispielsweise Kupferanreicherung im Elektrolyten, der Behandlungskammer 11 wieder zugeführt.

Auf der Oberfläche des Gegenstandes 13 und in gewissen Maße auch auf den Kontaktflächen 25 der Kontaktsektoren 24, die in Elektrolyten laufen, wird, soweit diese kathodisch angeschlossen sind, Metall aus den Elektrolyten abgeschieden. Von diesen Kontaktflächen 25, die, ebenso wie die Elektrodenflächen 71, aus für den Galvanikprozeß inertem Material bestehen, wird jedoch das im Stromzuführungsbereich aufgetragene Metall wieder abgetragen und geht wieder in Elektrolyten in Lösung, ohne daß dazu Hilfskathoden nötig wären oder feste Partikel entstehen, die den Elektrolyten verunreinigen könnten. Diese Flächen werden also stets und unmittelbar anschließend an ihre unerwünschte Metallisierung wieder entmetallisiert. Inertmaterialien für die Elektrode 71 oder die Kontaktierflächen 25 können z.B. Graphit, Edelstahl, Titan, Platin o. dgl. sein, je nach den Prozeßbedingungen.

Es ist zu erkennen, daß durch die Ausbildung der Transportwalzen als Elektroden diese nicht nur außerordentlich großflächig sein können, was zu einen geringen Spannungsbedarf und zur Schonung des Elektrolyten beiträgt, sondern es ist auch ein geringer, aber kontrolliert gleichmäßiger Abstand zwischen Kathode (Gegenstand 13) und Anode (Elektrode 71) sichergestellt, wobei die ring- oder scheibenförmigen Führungsteile 42 einen genauen Abstand sicherstellen. Bevorzugt können alle Transportwalzen Elektrodenflächen bilden. Es könnten aber auch nur einzelne sein. Bei einer einseitigen Beschichtung könnte beispielsweise nur der obere oder untere Teil des Rollenförderers Elektroden enthalten oder als solche strombeaufschlagt werden. Eine gleichmäßige Behandlung ist sichergestellt, wenn die Laufflächen 43 bei axial aufeinander folgenden Transportwalzen gegeneinander versetzt oder, wie eingangs schon beschrieben, über den Umfang der Transportwalze schräg verlaufen, z.B. nach Art einer Schraube oder Taumelscheibe.

## Patentansprüche

1. Einrichtung zur Behandlung von Gegenständen (13), insbesondere Galvanisiereinrichtung für Leiterplatten o. dgl., auf einer Durchlaufbahn (12) durch eine Behandlungskammer (11), mit Transportmitteln (14) für den Transport der Gegenstände (13) durch ein Behandlungsmedium (40) wie eine Elektrolytlösung, und mit Kontaktiermitteln (15) zur elektrischen Kontaktierung und Stromzuführung von einer Stromversorgung (36) zu den Gegenständen (13), und mit wenigstens einer Elektrode (71), die eine der zur Behandlung vorgesehenen Polarität der Gegenstände (13) entgegengesetzte Polarität aufweist, dadurch gekennzeichnet, daß die Elektrode (71) an einem Transportmittel (14) ausgebildet ist.

2. Einrichtung nach Anspruch 1, dadurch gekennzeichnet, daß die Elektrode (71) an einer Transportwalze (70) eines Rollenförderers ausgebildet ist, insbesondere an einer ggf. als Rohr ausgebildeten Welle (41) der Transportwalze (41), wobei die Gegenstände (13) mittels elektrisch isolierenden Führungsteilen (42), insbesondere Ringen oder Scheiben, geführt sind.

3. Einrichtung nach Anspruch 2, dadurch gekennzeichnet, daß die Führungsteile (42) axial zur Transportwalze (70) soweit voneinander in Abstand sind, daß ein überwiegender Oberflächenanteil der Welle (41) als Elektrodenfläche freiliegt und/oder die Welle (41) einen größeren Durchmesser hat als ihr radialer Abstand von den Gegenständen (13).

4. Einrichtung nach Anspruch 2 oder 3, dadurch gekennzeichnet, daß die die Gegenstände (13) führenden Laufflächen (43) der Führungsteile (42) über den Umfang der Transportwalze (70) ihre axiale Position ändern, beispielsweise mit einer schraubenartigen Steigung versehen sind oder als Taumelscheibe ausgebildet sind.

5. Einrichtung nach einem der vorhergehenden Ansprüche, dadurch gekennzeichnet, daß eine Stromzuführung zu den Transportmitteln über außerhalb der Behandlungskammer (11) angeordnete Schleifkontakte (76) erfolgt.

6. Einrichtung nach einem der vorhergehenden Ansprüche, dadurch gekennzeichnet, daß die Elektrode (71) aus im Behandlungsmedium weitgehend unlöslichem Material besteht bzw. mit einer solchen Beschichtung versehen ist.

7. Einrichtung nach einen der vorhergehenden Ansprüche, dadurch gekennzeichnet, daß das Behandlungsmedium (40) außerhalb des Behandlungsbereiches, insbesondere außerhalb der Behandlungskammer (11), aufbereitet, insbeson dere, bei einer galvanischen Beschichtungsbehandlung, mit dem Beschichtungsmaterial versehen bzw. angereichert wird.

8. Einrichtung nach einem der vorhergehenden Ansprüche, dadurch gekennzeichnet, daß die Transportmittel (14) für einen horizontalen Transport der Gegenstände (13) in horizontaler Ausrichtung aus oberen und unteren Transportwalzen (70) aufgebaut sind und vorzugsweise jeweils mehrere aufeinanderfolgende und/oder einander gegenüberliegende Transportwalzen (70) mit Elektroden (71) versehen sind.

9. Einrichtung nach einem der vorhergehenden Ansprüche, dadurch gekennzeichnet, daß die Kontaktiermittel (15) mehrere, wenigstens zwei, elektrisch voneinander isolierte, elektrisch unterschiedlich kontaktierte Kontaktsektoren (24) aufweisen.

10. Einrichtung nach Anspruch 9, dadurch gekennzeichnet, daß nicht in Kontakt mit den Gegenständen stehende Kontaktsketoren (24) an eine der Polarität der Gegenstände (13) entgegengesetzte Polarität angeschlossen sind, wobei vorzugsweise die Kontaktiermittel (15) in einer von der übrigen Behandlungskammer (11) weitgehend abgetrennten, jedoch mit Behandlungsmedium (40) gefüllten Kontaktierkammer (45) angeordnet sind und ggf. auf einen zur Kontaktierung vorgesehenen Galvanorand (48) der Gegenstände (13) einwirken.
